Europäisches Patentamt

European Patent Office

Office européen des brevets

(19)

(11) Veröffentlichungsnummer : **0 058 879**
**B1**

(12) # EUROPÄISCHE PATENTSCHRIFT

(45) Veröffentlichungstag der Patentschrift :
21.11.85

(21) Anmeldenummer : 82100954.5

(22) Anmeldetag : 10.02.82

(51) Int. Cl.⁴ : **G 01 R 27/02**, G 01 R 31/12,
G 01 N 27/20

(54) **Prüfverfahren bei der Herstellung von elektrischen Wicklungen, z. B. für Transformatoren, und Anordnung zur Durchführung des Verfahrens.**

(30) Priorität : 19.02.81 SE 8101112

(43) Veröffentlichungstag der Anmeldung :
01.09.82 Patentblatt 82/35

(45) Bekanntmachung des Hinweises auf die Patenterteilung : 21.11.85 Patentblatt 85/47

(84) Benannte Vertragsstaaten :
BE CH DE FR GB LI SE

(56) Entgegenhaltungen :
DE-A- 2 108 918
DE-A- 2 438 094
FR-A- 2 121 316
GB-A-   983 509
US-A- 3 955 136

(73) Patentinhaber : ASEA AB
S-721 83 Västeras (SE)

(72) Erfinder : Moritz, Bertil, Dipl.-Ing.
Anisstigen 3
S-771 00 Ludvika (SE)

(74) Vertreter : Boecker, Joachim, Dr.-Ing.
Rathenauplatz 2-8
D-6000 Frankfurt a.M. 1 (DE)

**Beschreibung**

Die Erfindung betrifft ein Prüfverfahren bei der Herstellung von elektrischen Wicklungen, z. B. für Transformatoren, der im Oberbegriff des Anspruches 1 genannten Art sowie eine Anordnung zur Durchführung des Verfahrens.

Bei der Herstellung einer Bandwicklung in einer Fabrikationsstätte läßt es sich praktisch nicht vermeiden, daß kleine Metallpartikel, wie zum Beispiel Eisen-, Kupfer- oder Aluminium-Partikel, als Verunreinigungen aus der Umgebung in die Wicklung gelangen. Solche in Herstellungsstätten nicht vermeidbaren Partikel haben oft scharfe Kanten, welche die Isolierung beschädigen und diese, wenn die Partikel groß genug sind, durchschneiden können, so daß sofort oder nach einer gewissen Betriebszeit der Wicklung ein Kurzschluß zwischen Windungen des Leiterbandes (der Metallfolie) auftreten kann. Da auch sehr kleine Partikel der genannten Art, die beispielsweise in der Größenordnung der Isolationsdicke liegen, welche bedeutend geringer als 0,1 mm sein kann, Schäden der genannten Art verursachen können, ist es praktisch sehr schwierig, eine Beschädigung der Wicklung durch Metallpartikel zu verhindern. Dies wäre nur denkbar unter Verwendung außerordentlich kostspieliger Reinigungsanlagen. Ein Windungskurzschluß kann auch durch Grate am Leiterband oder durch Fehler im Isolationsfilm verursacht werden.

Da die Herstellung einer Bandwicklung für einen großen Leistungstransformator hohe Material- und Lohnkosten verursacht, ist es wegen der oben genannten Gefahren aus wirtschaftlichen Gründen kaum zu verantworten, die Prüfung der Leiterisolation erst nach Fertigstellung der Wicklung durchzuführen.

Es ist bereits bekannt, die Spannungsfestigkeit eines Isolierfilms dadurch zu prüfen, daß man diesen zwischen zwei Walzen hindurchführt, zwischen denen eine elektrische Spannung liegt und die mit einer gewissen Kraft gegeneinander gedrückt werden (DE-OS 24 38 094). Bei isolierten Metallfolienbändern für Bandwicklungen genügt es jedoch nicht, nur den Isolierfilm zu prüfen, da ein an sich perfekter Isolierfilm während des Wickelvorganges durch Partikel beschädigt werden kann oder Grate an der Metallfolie den Film durchschneiden können.

Der vorliegenden Erfindung liegt die Aufgabe zugrunde, ein Verfahren bei der Herstellung von Bandwicklungen zu entwikkeln, bei welchem eventuelle Isolationsfehler bereits während des Wickelns festgestellt und behoben werden können.

Zur Lösung dieser Aufgabe wird ein Verfahren nach dem Oberbegriff des Anspruches 1 vorgeschlagen, welches erfindungsgemäß die im kennzeichnenden Teil des Anspruches 1 genannten Merkmale hat.

Vorteilhafte Weiterbildungen des Verfahrens nach der Erfindung sind in den Unteransprüchen 2 bis 4 genannt.

Eine Anordnung zur Durchführung des Verfahrens ist durch die im Anspruch 5 genannten Merkmale gekennzeichnet.

Vorteilhafte Weiterbildungen dieses Verfahrens sind in den Ansprüchen 6 bis 10 genannt.

Dadurch, daß man das Leiterband bei der Prüfung erdet und es nach einem doppelseitigen Aufbringen von Isolierfilm unter Rollen hindurchführt, die unter Spannung stehen, kann das isolierte Band kontinuierlich auf Fehlerfreiheit der Isolation geprüft werden. Wichtig ist, daß die Isolation des Bandes in zwei Teile aufgeteilt wird, die auf je einer Seite des Leiterbandes angeordnet werden. Dadurch kann jede Seite der Folie und jeder der beiden Isolierfilme für sich geprüft werden. Das Verfahren nach der Erfindung kann auch bei relativ breiten Leiterbändern angewendet werden, ohne daß die mit bekannten Verfahren verbundenen Unsicherheitsfaktoren auftreten.

Das Leiterband besteht vorzugsweise aus einer Aluminiumfolie, deren Dicke vorzugsweise zwischen 0,05 und 3 mm liegt. Als Isolation zwischen den Windungen der Aluminiumfolie kann vorzugsweise ein Polymerfilm dienen. Als Beispiel für geeignete Polymere für den Film können Polyäthylenglykolterephtalat, Polykarbonat, Polyimid, Zelluloseazetat und Polyamid genannt werden. Um einen gleichmäßigen Druck über die gesamte Breite des Bandes zu erhalten, kann man eine Elektrodenanordnung anwenden, die mindestens ein Walzenpaar enthält, wobei die eine Rolle des Walzenpaares eine sehr flexible Well ist, die einen bedeutend kleineren Durchmesser als die andere, als Stützwalze dienende Rolle hat. Die flexible Welle und die Stützwalze haben eine verhältnismäßig harte Oberfläche. Die flexible Welle wird von mehreren koaxial zueinander angeordneten in axialer Richtung kurzen Stützrollen gegen das Band gepreßt. Eine andere Möglichkeit besteht darin, daß man zwei verschiedene Walzenpaare zur Prüfung des Bandes auf beiden Seiten verwendet, wobei die unter Spannung stehende Walze jedes Walzenpaares eine Stahlwalze sein kann, während die andere Walze aus einem elektrisch isolierenden, elastischen Material, wie z. B. Gummi oder dergleichen, bestehen kann.

Die Isolationsprüfung wird zweckmäßigerweise mit Gleichspannung durchgeführt, da dabei der stationäre Leckstrom durch den Isolationsfilm im Verhältnis zu dem bei einem Isolationsfehler auftretenden Strom vernachlässigbar klein ist. Dadurch kann ein solcher Fehler leichter festgestellt werden, als wenn die Isolationsprüfung mit Welchselspannung durchgeführt wird. Wegen der verhältnismäßig großen Kapazität zwischen der an Spannung liegenden Rolle und dem Leiterband fließt nämlich bei Verwendung von Wechselspannung im Prüfkreis ein verhältnismäßig großer stationärer Verschiebungsstrom, der das Erkennen von Isolationsfehlern erschwert.

Anhand der in den Figuren gezeigten Ausführungsbeispielen von Durchführungsanordnungen für das Verfahren soll die Erfindung näher erläutert werden. Es zeigen

Figur 1 in schematischer Darstellung ein Ausführungsbeispiel für eine Anordnung zur Isolationsprüfung einer Bandwicklung gemäß der Erfindung,

Figur 2 in gleicher Darstellung wie Figur 1 ein weiterentwickeltes Ausführungsbeispiel der Anordnung nach Figur 1,

Figur 3 in Seitenansicht ein zu der Prüfanordnung nach Figur 1 oder 2 gehörendes Walzenpaar, das mit Organen zur Erzeugung eines über die gesamte Breite des Leiterbandes gleichmäßig verteilten Druckes versehen ist,

Figur 4 die Anordnung nach Figur 3 in Endansicht,

Figur 5 eine weitere Ausführungsform einer Prüfanordnung gemäß der Erfindung.

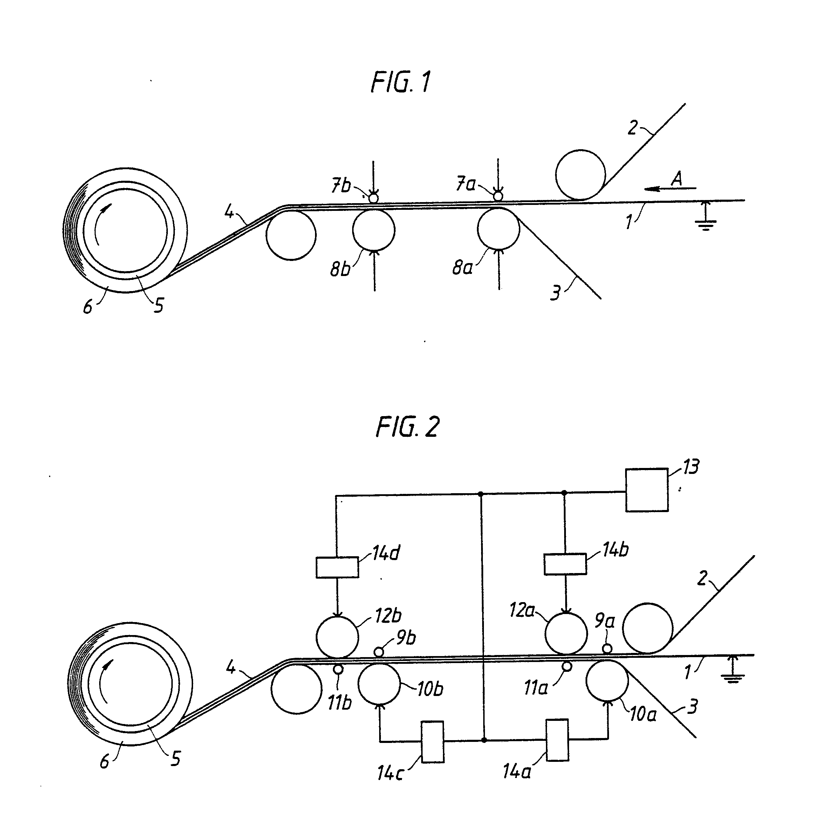

In Figur 1 wird ein Leiterband 1 in Form einer Folie aus Aluminium oder Kupfer gezeigt, das von einer nicht gezeigten Vorratsrolle in Richtung des Pfeils A abgewickelt wird, wobei die Folie auf ihren beiden Seiten mit Isolierfilmen 2, 3 belegt wird. Die Isolierfilme können beispielsweise durch Leimen, fest an der Folie fixiert werden ; sie können aber auch ohne Zwischenfügung eines Bindemittels auf der Folie aufgebracht werden. Das Leiterband mit den Isolierfilmen bildet ein Band 4, das auf einen Formzylinder 5 zu einer Bandrolle 6 aufgewickelt wird, welche beispielsweise als Wicklung in einem Transformator verwendet wird. Die Metallfolie kann eine Dicke von z. B. 0,5 mm und eine Breite von z. B. 1,5 m haben. Die Isolierfilme können eine Dicke von z. B. 0,05 mm haben und sollen etwas breiter als die Metallfolie sein, so daß sie über die Ränder der Metallfolie hinausragen und dadurch elektrische Überschläge längs der Stirnflächen der Wicklung verhindern.

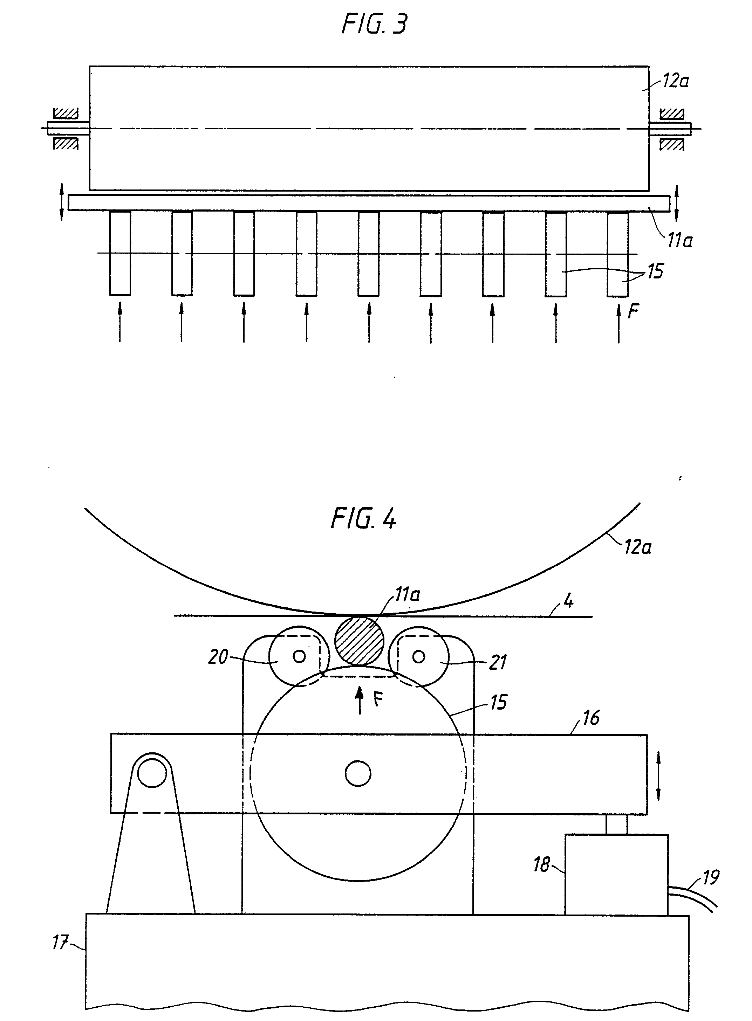

Während des Wickelns wird das Leiterband 1 geerdet und nach Aufbringung der Isolierfilme 2 und 3 wird das Band durch zwei unter Spannung stehende Elektrodenanordnungen geführt, die in Längsrichtung der Bandführungsbahn in einem Abstand voneinander angeordnet sind. Jede dieser Elektrodenanordnungen enthält zwei Walzen 7a, 8a, bzw. 7b, 8b, von denen je eine auf jeder Seite des Bandes angeordnet ist. In jedem Walzenpaar besteht eine Walze 7a, 7b aus einer sehr flexiblen Welle, auf die eine nachstehend anhand der Figuren 3 und 4 näher beschriebene Anordnung derart wirkt, daß die Welle mit einem über die gesamte Breite des Bandes gleichmäßig verteilten Anpreßdruck gegen das Band 4 anliegt. Die andere Walze 8a bzw. 8b jedes Walzenpaares hat einen wesentlich größeren Durchmesser als die flexible Welle und dient als Stützwalze. Der Durchmesser der flexiblen Wellen 7a, 7b kann beispielsweise 10 mm betragen, während der Durchmesser der Stützwalzen 8a, 8b z. B. 200 mm betragen kann. Die beiden Walzen jedes Walzenpaares haben eine verhältnismäßig harte Oberfläche.

Wenn das isolierte Band 4 die erste Elektrodenanordnung 7a, 8a passiert, wird der Isolationswert der Isolierfilme durch Messung des Leckstroms geprüft, der über jede Walze 7a, 8a durch den betreffenden Isolierfilm fließt. Wenn das Isolationsvermögen an irgendeinem Punkt auf einer Seite des Bandes herabgesetzt ist, spricht ein in der Anordnung angeordnetes Relais an, wodurch die Antriebsanordnung auf solche Weise gestoppt wird, daß sich die Fehlerstelle in dem Bereich zwischen den beiden Elektrodenanordnungen in einem bestimmten Abstand vom Walzenpaar 7a, 8a befindet. Danach wird ein Isolierfilmstreifen aufgebracht, der das Band in ganzer Breite auf derjenigen Seite bedeckt, auf welcher der Fehler festgestellt wurde. Man braucht den Fehler dabei nicht zu sehen, und das Auflegen des Streifens kann vollautomatisch geschehen. Danach geht der Wickelvorgang weiter, und eine erneute Spannungsprüfung wird am Walzenpaar 7b, 8b vorgenommen. Dank dieses Aufbaues braucht man die Anordnung nicht zurücklaufen zu lassen, um einen eventuell festgestellten Isolationsfehler beheben zu können.

Beide Walzen jedes Walzenpaares haben vorzugsweise dasselbe Potential. Es müssen ihnen jedoch individuelle Strommeßglieder zugeordnet sein, da es wünschenswert ist, unmittelbar feststellen zu können, auf welcher Seite des Bandes ein festgestellter Isolationsfehler liegt. Mit der Ausführung nach Figur 1 kann es jedoch schwierig sein, dies eindeutig festzustellen, da über die Endabschnitte der Walzen leicht ein metallischer Kontakt auftreten kann, denn die Länge der Walzen ist normalerweise größer als die Breite des Bandes 4 und die Dicke des Bandes ist gering. Diese Schwierigkeit wird bei der Ausführungsform gemäß Figur 2 vermieden, bei der jede Elektrodenanordnung zwei Walzenpaare 9a, 10a und 11a, 12a bzw. 9b, 10b und 11b, 12b enthält, wobei nur eine Walze 10a, 12a bzw. 10b, 12b jedes Walzenpaares spannungsführend ist, während die andere Walze 9a, 11a bzw. 9b, 11b isolierend ist. Figur 2 zeigt auch den Prüfspannungsgenerator 13 und die Stromerfassungsorgane 14a-14d. Der Spannungsanschluß an die einzelnen Walzen erfolgt über federnd angedrückte Kohlebürsten.

Die Figuren 3 und 4 zeigen, wie die Vorrichtung zur Erzeugung eines über die Breite des Bandes 4 gleichmäßigen Anpreßdrukkes aufgebaut sein kann. Diese Vorrichtung enthält eine grosse Anzahl koaxial zueinander angeordneter Rollen 15, beispielsweise 30 Stück, die gleichmäßig längs der Welle 11a verteilt sind. Jede Rolle ist in einem Arm 16 (siehe Figur 4) gelagert, der seinerseits mit einem Ende drehbar in einem Stativ 17 gelagert ist und mit seinem anderen Ende an einen pneumatischen Druckzylinder 18 angeschlossen ist. Über eine Leitung 19 wird dem Druckzylinder Druckluft zugeführt, so daß die dazugehörige Rolle 15, und auf gleiche Weise auch die übrigen Rollen 15, mit einer Kraft F gegen die flexible Welle 11a gepreßt wird, die dabei mit einem Druck, der im wesentlichen über die ganze Breite des Bandes gleich groß ist, an dem Band 4 anliegt. Die Welle 11a wird von zwei neben jeder Rolle 15 diametral zur Welle 11a angeordneten Stützrollen 20, 21, die in dem Stativ 17 gelagert sind, in ihrer Lage gehalten. Die Welle 11a braucht im Prinzip nicht an ihren Enden gelagert zu sein. Doch kann es eventuell trotzdem praktisch sein, sie mit einer solchen Lagerung zu versehen, die dabei jedoch derart aufgebaut ist, daß die Bewegung der Welle radial zur Stützwalze 12a nicht blockiert wird.

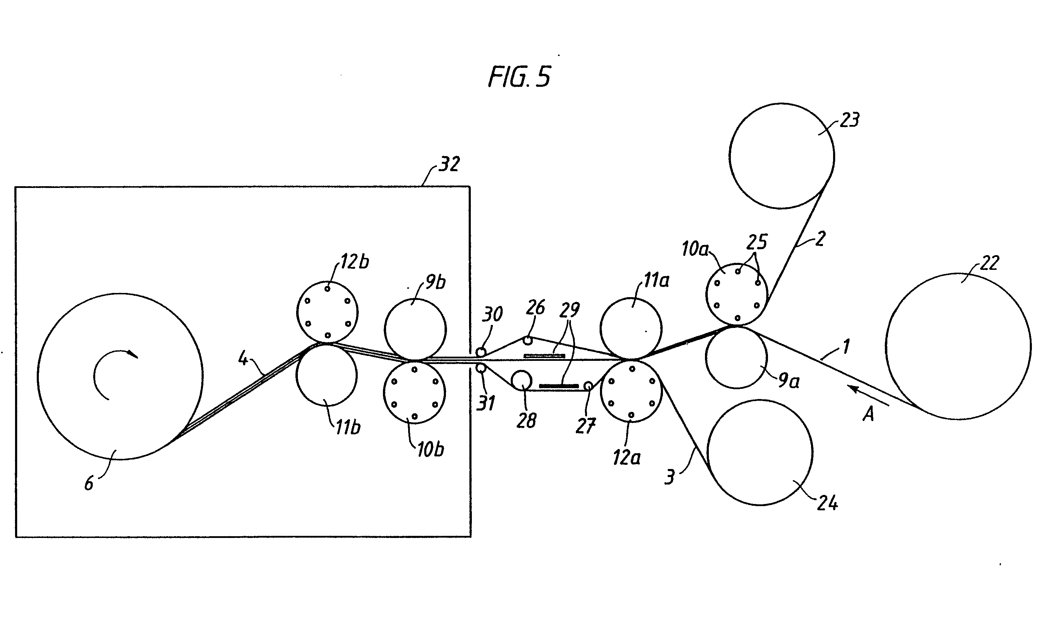

Bei der Anordnung nach Figur 5 wird von einer Vorratsrolle 22 eine Metallfolie 1 in Richtung des Pfeils A abgewickelt, und zwei Isolierfilme 2, 3 werden von den Vorratsrollen 23 bzw. 24 zu beiden Seiten der Folie 1 abgewickelt. In einer ersten Prüfstation, die zwei Walzenpaare 9a, 10a bzw. 11a, 12a umfaßt, wird der Isolationswert der Isolierfilme jeweils für sich geprüft, wobei die Isolierfilme mit einer bestimmten Kraft gegen die Oberfläche der Metallfolie gedrückt werden. Die eine Walze 10a bzw. 12 jedes Walzenpaares besteht zumindest an ihrer Manteloberfläche aus Metall, wie z. B. Stahl, und dient bei der Isolationsprüfung als die eine Elektrode, während die Metallfolie 1 als zweite Elektrode dient. Die andere Walze 9a bzw. 11a jedes Walzenpaares besteht zumindest in einer an der Mantelfläche liegenden Schicht aus elektrisch isolierendem, elastischem Material, wie z. B. Gummi, wodurch man eine einigermaßen gleichmäßige Druckverteilung über die Breite des Bandes erreicht.

Innerhalb der an Spannung liegenden Walzen 10a und 12a sind elektrische Heizstäbe 25 angeordnet, die mit den Walzen 10a, 12a rotieren und diese warm halten. Auf diese Weise werden Film und Folie beim Passieren des betreffenden Walzenpaares nicht nur einem Druck und einer Spannung, sondern auch einer Wärmeeinwirkung ausgesetzt.

Nach dem Passieren des Walzenpaares 11a, 12a werden die Isolierfilme 2, 3 mit Hilfe von Umlenkrollen 26, 27 und 28 von der Metallfolie 1 abgehoben. Dadurch können Reparaturstreifen 29 aus Isolierfilm zwischen Film und Folie geschoben werden, wenn auf irgendeiner Seite der Folie ein Isolationsfehler festgestellt wird. Dadurch, daß die Reparaturstreifen von der Seite eingeschoben und von dem Film an ihrem Platz gehalten werden, wird verhindert, daß andere Gegenstände zwischen Film und Folie gelangen, und man vermeidet Probleme bei der Befestigung der Reparaturstreifen.

Nach einer eventuellen Reparatur werden die Isolierfilme 2, 3 und die Folie 1 mit Hilfe eines Rollenpaares 30, 31 wieder zusammengeführt, worauf die Filme und die Folie in einen gekapselten, sauber gehaltenen Raum 32 eintreten. Um zu kontrollieren, daß nach der ersten Prüfung keine Beschädigung oder Verschmutzung von Film oder Folie eingetreten ist, wird die Prüfung auf die gleiche Weise in einer zweiten Prüfstation wiederholt, die in dem gekapselten Raum 32 liegt und die genau wie die erste Prüfstation zwei Walzenpaare 9b, 10b und 11b, 12b umfaßt. Wenn hier Isolationsfehler festgestellt werden, wird die Maschine rückwärts gefahren, und die Reparatur geschieht außerhalb des Raumes 32 an der dafür vorgesehenen Stelle in der Maschine.

## Patentansprüche

1. Prüfverfahren bei der Herstellung von elektrischen Wicklungen (6), z. B. für Transformatoren oder Drosselspulen, welche Wicklungen aus einer Vielzahl aufeinandergewickelter Windungen eines Bandes (4) aufgebaut sind, das aus einer Metallfolie (1) une auf beiden Seiten der Metallfolie angebrachten Isolierfilmen (2, 3) zusammengesetzt ist, wobei die Metallfolie als Leiter und die Isolierfilme als Isolierung der Leiter dienen, dadurch gekennzeichnet, daß die Metallfolie (1) während des Wickelvorganges zusammen mit den Isolierfilmen (2, 3) durch mindestens eine Elektrodenanordnung geführt wird, die mindestens zwei auf je einer Seite des Bandes liegende und gegenüber der Metallfolie (1) unter Spannung stehende Walzen (10a, 12a) enthält, welche die Isolierfilme (2, 3) mit einem bestimmten Druck über die ganze Breite des Bandes gegen die Metallfolie (1) pressen, und daß zur Prüfung des Isolationszustandes auf beiden Seiten des Bandes separat für jede Seite der Leckstrom gemessen wird, der von jeder der genannten Walzen (10a, 12a) durch den betreffenden Isolierfilm (3, 2) fließt, und daß, wenn der Leckstrom einen bestimmten Wert übersteigt, die Isolation an der fehlerbehafteten Stelle verstärkt wird.

2. Verfahren nach Anspruch 1, dadurch gekennzeichnet, daß bei der Anzeige eines Isolationsfehlers ein zusätzlicher Isolierstreifen (29) über die Fehlerstelle gelegt wird, dessen Länge mindestens so groß wie die Breite der Metallfolie ist.

3. Verfahren nach Anspruch 2, dadurch gekennzeichnet, daß der Isolierstreifen (29) von der Seite her zwischen die Metallfolie (1) und den betreffenden Isolierfilm (2, 3) in das Band (4) gelegt wird.

4. Verfahren nach einem der vorhergehenden Ansprüche, dadurch gekennzeichnet, daß das Band (4) zur Durchführung einer erneuten Isolationsprüfung durch eine zweite Elektrodenanordnung geführt wird, die in Wicklungsrichtung in einem gewissen Abstand vor der ersten Elektrodenanordnung angeordnet ist und die ebenfalls mit spannungsführenden Walzen (10b, 12b) versehen ist.

5. Prüfanordnung für die Herstellung von elektrischen Wicklungen (6) für beispielsweise Transformatoren oder Drosselspulen, welche Wicklungen aus einer Vielzahl aufeinandergewickelter Windungen eines Bandes (4) aufgebaut sind, das aus einer Metallfolie (1) und auf beiden Seiten der Metallfolie angebrachten Isolierfilmen (2, 3) zusammengesetzt ist, wobei die Metallfolie als Leiter und die Isolierfilme als Isolierung der Leiter dienen, dadurch gekennzeichnet, daß die Anordnung mindestens eine Elektrodenanordnung enthält, die mindestens zwei auf je einer Seite des Bandes (4) angeordnete Walzen (10a, 12a) aufweist, welche mit Druck auf der ganzen Breite des Bandes an diesem anliegen, die ferner eine Spannungsquelle (13) aufweist, welche elektrisch zwischen den Walzen einerseits und der Metallfolie andererseits liegt, die ferner Meßglieder (14a, 14b) aufweist zur Messung eines eventuellen Leckstroms, der von jeder der genannten Walzen über den betreffenden Isolierfilm (3, 2) zur Metallfolie fließt, und daß Organe vorhanden sind, welche den Wickelvorgang zwecks Verstärkung der Isolation vorübergehend stoppen können, wenn der Leckstrom einen bestimmten Wert übersteigt.

6. Anordnung nach Anspruch 5, dadurch gekennzeichnet, daß die genannte Elektrodenanordnung zwei Walzenpaare mit je zwei gegeneinander gedrückte Walzen enthält, wobei die eine Walze jedes Walzenpaares eine der genannten an die Spannungsquelle angeschlossenen Walzen (10a, 12a) ist, während die andere Walze (9a, 11a) des betreffenden Walzenpaares zumindest in einer an der Manteloberfläche liegenden Schicht aus einem elastischen, elektrisch isolierenden Material besteht.

7. Anordnung nach Anspruch 5, dadurch gekennzeichnet, daß die eine Walze (9a, 11a) jedes Walzenpaares aus einer Welle besteht, die in radialer Richtung relativ flexibel ist, jedoch eine harte Oberfläche hat, und daß mehrere koaxial zueinander angeordnete kürzere Stützrollen (15) vorhanden sind, die derart gegen die genannte Welle (9a, 11a) gepreßt werden, daß die Welle mit einem in ihrer Längsrichtung im wesentlichen gleichmäßig verteilten Druck an dem Band (4) anliegt.

8. Anordnung nach einem der Ansprüche 5 bis 7, dadurch gekennzeichnet, daß zwei Elektrodenanordnungen (9a-12a bzw. 9b-12b) der genannten Art zur Isolationsprüfung unter mechanischem Druck auf beiden Seiten des Bandes vorhanden sind und daß diese beiden Elektrodenanordnungen in einem solchen Abstand voneinander längs der Bandführungsbahn liegen, daß eine eventuell erforderliche Isolationsverstärkung an der zwischen den beiden Elektrodenanordnungen liegenden Bandstrecke vorgenommen werden kann.

9. Anordnung nach einem der Ansprüche 5 bis 8, dadurch gekennzeichnet, daß die Anordnung Organe (25) zur Erwärmung der Isolierfilme (2, 3) während der Isolationsprüfung enthält.

10. Anordnung nach Anspruch 9, dadurch gekennzeichnet, daß die Erwärmungsorgane (25) elektrische Heizelemente sind, die in die an Spannung liegenden Walzen (10a, 12a) eingebaut sind.

## Claims

1. Test method for the manufacturing of electric windings (6), for example for transformers or reactive coils, which windings are built up of a plurality of turns of a sheet (4) wound one upon the other, said sheet being composed of a metallic foil (1) and electrically insulating films (2, 3) applied to each side of said metallic foil, the metallic foil acting as conductor and the insulating films acting as insulator of said conductor, characterized in that during the winding process the metallic foil (1) together with the insulating films (2, 3) are passed through at least one electrode device including at least two rolls (10a, 12a) being positioned each one on side of said sheet, having a voltage relative to the metallic foil (1), and pressing the insulating film (2, 3) with a certain pressure against the metallic foil (1) across the entire width of said sheet, and that for testing the insulating condition on both sides of the sheet separate measurements are taken on each side of the sheet to determine the leakage current passing from each of said rolls (10a, 12a) through the respective insulating film (3, 2), and that in case of the leakage current exceeding a predetermined value the insulation is reinforced at the defect location.

2. Method according to claim 1, characterized in that in case of detecting an insulation fault, an additional insulating strip (29) the length of which is at least equal with the width of said metallic foil is applied across the location of the fault.

3. Method according to claim 2, characterized in that the insulating strip (29) is inserted from the side of the sheet (4) between the metallic foil (1) and the respective insulating film (2, 3).

4. Method according to any of the preceding claims, characterized in that for performing a further testing of the insulation the sheet (4) is passed through a second electrode device which in direction of travel of the sheet is located in a certain distance in front of said first electrode device and is also provided with rolls (10b, 12b) applied to a voltage.

5. Testing means for the manufacturing of electric windings (6), for example for transformers or reactive coils, which windings are built up of a plurality of turns of a sheet (4) wound one upon the other, said sheet being composed of a metallic foil (1) and electrically insulating films (2, 3) applied to each side of said metallic foil, the metallic foil acting as conductor and the insulating films acting as insulator of said conductor, characterized in that the means includes at least one electrode device, which includes at least two rolls (10a, 12a) being positioned each one on side of said sheet (4) and abutting under pressure against said sheet across the entire width of the sheet, that the means further includes a voltage source (13) being electrically connected between the rolls on one side and the metallic foil on the other side, that the means further include measuring devices (14a, 14b) for measuring a possible leakage current passing from any of said rolls through the respective insulating film (3, 2) to the metallic foil, and that members are provided capable of temporarily interrupting the winding process if the leakage current exceeds a predetermined value.

6. Means according to claim 5, characterized in that said electrode device includes two pairs of rolls the two rolls in each pair being pressed against each other, whereby one roll in each pair of rolls represents one of said rolls (10a, 12a) connected to a voltage source, while the other roll (9a, 11a) of the respective pair of rolls consists at least in a layer including its generated surface of elastic, electrically insulating material.

7. Means according to claim 5, characterized in that one roll (9a, 11a) in each pair of rolls consists of a shaft being relatively flexible in the radial direction but having a hard surface and that there is a plurality of shorter supporting rolls (15) being arranged coaxially to each other and being pressed against said shaft (9a, 11a) such that said shaft contacts said sheet (4) with a substantially evenly distributed pressure in its longitudinal direction.

8. Means according to any of claim 5 to 7, characterized in that it comprising two of said electrode devices (9a-12a resp. 9b-12b) for testing the insulation under mechanical pressure on either side of the sheet, and that both said electrode devices are positioned along the path of travel of the sheet in such a distance from each other, that a possibly necessary reinforcement of the insulation can be performed along the sheet path between the two electrode devices.

9. Means according to any of claim 5 to 8, characterized in that the means includes devices (25) for heating said insulating films (2, 3) during the testing of the insulation.

10. Means according to claim 9, characterized in that the heating devices (25) are of electrical type being accommodated within said tension-connected rolls (10a, 12a).

**Revendications**

1. Procédé de contrôle, lors de la fabrication d'enroulements électriques (6), par exemple pour des transformateurs ou des bobines de réactance, lesquels enroulements sont constitués par une pluralité de spires enroulées l'une sur l'autre d'un ruban (4) qui est constitué par un feuillard métallique (1) et par des pellicules isolantes (2, 3) disposées sur les deux côtés du feuillard métallique, le feuillard métallique servant de conducteur et les pellicules isolantes d'isolation du conducteur, caractérisé par le fait que le feuillard métallique (1) est guidé, pendant l'opération d'enroulement, avec les pellicules isolantes (2, 3), à travers au moins un agencement à électrodes qui comporte au moins deux cylindres (10a, 12a) sous tension, situés respectivement de part et d'autre du ruban et appliquant les pellicules isolantes (2, 3) avec une certaine pression et sur toute la largeur du ruban, contre le feuillard métallique (1), et que pour le contrôle de l'état de l'isolation sur les deux côtés du ruban, on mesure séparément pour chaque côté le courant de fuite qui passe de chacun desdits cylindres (10a, 12a) par la pellicule isolante (3, 2) concernée, et que l'isolation de l'emplacement défectueux est renforcée lorsque le courant de fuite dépasse une valeur déterminée.

2. Procédé selon la revendication 1, caractérisé par le fait que dans le cas de l'indication d'un défaut de l'isolation, on place une bande isolante supplémentaire (21) sur l'emplacement défectueux, et dont la longueur est au moins aussi grande que la largeur du feuillard métallique.

3. Procédé selon la revendication 2, caractérisé par le fait que la bande isolante (29) est placée dans le ruban (4) à partir du côté, entre le feuillard métallique (1) et la pellicule isolante concernée (2, 3).

4. Procédé selon l'une des revendications précédentes, caractérisé par le fait que le ruban (4) est guidé, pour la réalisation d'un nouveau contrôle de l'isolation, à travers un second agencement à électrodes, qui est disposé à une certaine distance du premier agencement à électrodes, dans le sens de l'enroulement, et qui est également pourvu de cylindres sous tension (10b, 12b).

5. Dispositif de contrôle pour la fabrication d'enroulements électriques (6), par exemple pour des transformateurs ou des bobines de réactance, lesquels enroulements sont constitués par une pluralité de spires enroulées l'une sur l'autre d'un ruban (4) qui est constitué par un feuillard métallique (1) et par des pellicules isolantes (2, 3) disposées sur les deux côtés du feuillard métallique, le feuillard métallique servant de conducteur et les pellicules isolantes d'isolation du conducteur, caractérisé par le fait que le dispositif comporte au moins un agencement à électrodes qui comporte au moins deux cylindres (10a, 10b) disposés respectivement sur un côté du ruban (4), et qui portent, avec pression, et sur toute la largeur du ruban, sur ce dernier, qu'il comporte en outre, une source de tension (13) qui est disposée électriquement entre les cylindres, d'une part, et le feuillard métallique, d'autre part, qu'il comporte en outre des éléments de mesure (14a, 14b) pour la mesure d'un courant de fuite éventuel qui passe, de chacun desdits cylindres et par l'intermédiaire de la pellicule isolante concernée (3, 2) vers le feuillard métallique, et que des organes sont prévus qui peuvent arrêter passagèrement l'opération d'enroulement en vue du renforcement de l'isolation, lorsque le courant de fuite dépasse une valeur déterminée.

6. Dispositif selon la revendication 5, caractérisé par le fait que ledit agencement à électrodes comporte des paires de cylindres avec respectivement deux cylindres appliqués l'un contre l'autre, l'un des cylindres de chaque paire de cylindres étant l'un desdits cylindres (6a, 12a) reliés à la source de tension, alors que l'autre cylindre (9a, 11a) de la paire de cylindre concernée est constitué par un matériau élastique, électriquement isolant, au moins dans une couche qui se situe sur la surface latérale.

7. Dispositif selon la revendication 5, caractérisé par le fait que l'un des cylindres (9a, 11a) de chaque paire de cylindres est constitué par un arbre qui est relativement flexible en direction radiale, mais présente toutefois une surface dure, et que sont prévus plusieurs galets d'appui (15) plus courts et disposés coaxialement entre eux, lesquels galets sont appliqués de telle façon contre ledit arbre (9a, 11a) que celui-ci porte contre le ruban (4) avec une pression qui est répartie sensiblement de façon uniforme dans son sens longitudinal.

8. Dispositif selon l'une des revendications 5 à 7, caractérisé par le fait que deux agencements à électrodes (9a-12a ; 9b-12b) du genre sus-mentionné et servant de contrôle de l'isolation sous pression métallique sont prévus de part et d'autre du ruban, et que ces deux agencements à électrodes sont disposés à une telle distance l'un de l'autre le long de la voie de guidage du ruban qu'un renforcement de l'isolation qui est éventuellement nécessaire est opéré sur la voie du ruban qui se situe entre les deux agencements à électrodes.

9. Dispositif selon l'une des revendications 5 à 8, caractérisé par le fait que le dispositif comprend des organes (25) pour chauffer les pellicules isolantes (2, 3) pendant le contrôle de l'isolation.

10. Dispositif selon la revendication 9, caractérisé par le fait que les organes de chauffage (25) sont des éléments électriques de chauffage qui sont montés dans les cylindres (10a, 12a) qui sont sous tension.

# FIG. 1

# FIG. 2

## FIG. 3

## FIG. 4

FIG. 5